# EUROPEAN PATENT SPECIFICATION

(11) **EP 3 598 563 B1**
(45) Date of publication and mention of the grant of the patent: **01.06.2022**
(21) Application number: 18768050.9
(22) Date of filing: 01.03.2018
(51) Int. Cl.: H01M 10/36, H01M 4/48, H01M 10/38, H01M 4/52, H01M 14/00

(54) **ELECTRICITY STORAGE DEVICE**
STROMSPEICHERVORRICHTUNG
DISPOSITIF DE STOCKAGE D'ÉLECTRICITÉ

(30) Priority: 15.03.2017 JP 2017049544
(43) Date of publication of application: 22.01.2020
(73) Proprietor: Kabushiki Kaisha Nihon Micronics, Musashino-shi, Tokyo 180-8508 (JP)
(72) Inventor: TONOKAWA, Takashi, Musashino-shi Tokyo 180-8508 (JP); TSUNOKUNI, Kazuyuki, Musashino-shi Tokyo 180-8508 (JP); KUDOH, Takuo, Musashino-shi Tokyo 180-8508 (JP)
(74) Representative: Samson & Partner Patentanwälte mbB
(86) International application number: PCT/JP2018/007770
(87) International publication number: WO 2018/168493

(56) References cited:
- WO-A1-2016/208116
- WO-A1-2017/199618
- JP-A- 2015 082 445
- JP-A- 2016 082 125
- JP-A- 2016 127 166
- JP-A- 2017 059 524
- JP-A- 2017 182 969
- JP-A- 2017 195 283
- JP-A- 2018 022 719
- JP-A- 2018 037 261
- US-A1- 2013 224 596

## Description

### TECHNICAL FIELD

The embodiments described herein relate to an electricity storage device.

### BACKGROUND ART

As conventional electricity storage devices, there have been proposed secondary batteries, in which a first electrode / an insulating material / an n type oxide semiconductor layer / a p type oxide semiconductor layer / a second electrode are layered, since electrolytic solutions and rare elements are not used and thinning thereof can be realized.

Moreover, as a structure similar to such secondary batteries, there have been proposed secondary batteries including: a positive electrode including a positive-electrode active material layer containing a nickel oxide or the like as a positive-electrode active material; a solid electrolyte having an aqueous porous structure; and a negative electrode including a negative-electrode active material layer containing a titanium oxide or the like as a negative-electrode active material.

Moreover, there have also been proposed electricity storage devices having a structure in which an n type semiconductor layer, a charge layer, an insulation layer, and a p type semiconductor layer are layered, and electrodes are formed at upper and lower sides thereof.

Patent Literature 1: Japanese Patent No. 5508542
Patent Literature 2: Japanese Patent No. 5297809
Patent Literature 3: Japanese Patent Application Laid-Open Publication No. 2015-82445
Patent Literature 4: Japanese Patent Application Laid-Open Publication No. 2016-82125

Patent literature 3 discloses an electricity storage device made up of a stack of ITO / TiO2 (n-type oxide semiconductor) / Silicon oxide deposited from silicone oil as a solid electrolyte / NiO (n-type oxide semiconductor). Furthermore, nickel hydroxide and nickel oxyhydroxide are mentioned as particularly preferable materials for the positive active material, i.e. as an alternative to NiO.

US2013/224596A1 discloses a secondary battery including a stack comprising the following layers: substrate 12, a conductive ITO first electrode 14, a TiO2 n-type metal oxide semiconductor layer 16, a charging layer 18, a NiO p-type metal oxide semiconductor layer 20, and a second electrode 22. The charging layer comprises TiO2 particles coated with silicone or SiO2.

### SUMMARY OF INVENTION

### Technical Problem

The embodiments provide an electricity storage device capable of increasing an electricity storage capacity per unit volume (weight).

### Solution to Problem

According to one aspect of the embodiments, there is provided an electricity storage device comprising: a first oxide semiconductor layer having a first conductivity-type first oxide semiconductor; a first charge layer disposed on the first oxide semiconductor layer, the first charge layer composed by comprising a first insulating material and a second oxide semiconductor, the second oxide semiconductor having the first conductivity-type; and a third oxide semiconductor layer disposed on the first charge layer, wherein the third oxide semiconductor layer has hydrogen and a second conductivity-type third oxide semiconductor, and a percentage of the hydrogen with respect to a metal constituting the third oxide semiconductor is equal to or greater than 40%.

### Advantageous Effects of Invention

According to the embodiments, there can be provided the electricity storage device capable of increasing the electricity storage capacity per unit volume (weight).

### BRIEF DESCRIPTION OF THE DRAWINGS

[Fig. 1] A schematic cross-sectional structure diagram showing an electricity storage device according to the embodiments.
[Fig. 2] (a) A schematic configuration diagram showing a third oxide semiconductor layer which contains hydrogen, and (b) another schematic configuration diagram showing the third oxide semiconductor layer which contains hydrogen, in the electricity storage device according to the embodiments.
[Fig. 3] A relationship between an amount of discharged charge Q_{D} and an amount of hydrogen C_{H} in a p type oxide semiconductor layer, in the electricity storage device according to the embodiments.
[Fig. 4] A relationship between the amount of discharged charge Q_{D} and a thickness tₚ of the p type oxide semiconductor layer, in the electricity storage device according to the embodiments.
[Fig. 5] A measured result of X-ray diffraction (XRD) of the p type oxide semiconductor layer, in the electricity storage device according to the embodiments.
[Fig. 6] A schematic diagram for explaining a relationship between an amount of hydrogen C_{H} of the p type oxide semiconductor layer and a pressure ΔP in sputter deposition, in the electricity storage device according to the embodiments.
[Fig. 7] A schematic diagram for explaining a relationship between discharging time T_{D} and the thickness tₚ of the p type oxide semiconductor layer, in the electricity storage device according to the embodiments.
[Fig. 8] A schematic diagram for explaining a relationship between the discharging time T_{D} and a thickness t_{ch} of a first charge layer, in the electricity storage device according to the embodiments.
[Fig. 9] A schematic configuration diagram showing a sputter deposition apparatus, for the electricity storage device according to the embodiments.

### DESCRIPTION OF EMBODIMENTS

Next, the embodiments will be described with reference to drawings. In the description of the following drawings, the identical or similar reference sign is attached to the identical or similar part. However, it should be noted that the drawings are schematic and therefore the relation between thickness and the plane size and the ratio of the thickness differs from an actual thing. Therefore, detailed thickness and size should be determined in consideration of the following explanation. Of course, the part from which the relation and ratio of a mutual size differ also in mutually drawings is included.

Moreover, the embodiments shown hereinafter exemplify the apparatus and method for materializing the technical idea; and the embodiments do not specify the material, shape, structure, placement, etc. of each component part as the following. The embodiments may be changed without departing from the scope of claims.

In explanation of following embodiments, a first conductivity type means an n type and a second conductivity type means a p type opposite to the first conductivity type, for example. The first conductivity-type first oxide semiconductor 14 means an oxide semiconductor layer having a first conductivity-type first oxide semiconductor. The second conductivity-type third oxide semiconductor layer 24 means an oxide semiconductor layer having a second conductivity-type third oxide semiconductor. The same applies hereafter.

### [Embodiments]

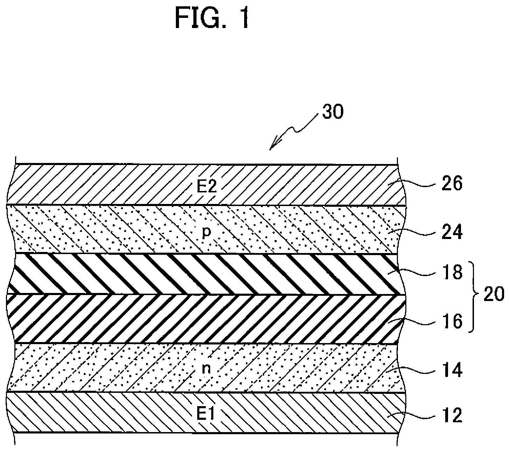

As shown in Fig. 1, an electricity storage device 30 according to the embodiments includes: a first oxide semiconductor layer 14 having a first conductivity-type first oxide semiconductor; a first charge layer 16 disposed on the first oxide semiconductor layer, and composed by including a first insulating material and a first conductivity-type second oxide semiconductor; and a third oxide semiconductor layer 24 disposed on the first charge layer 16. In the embodiments, the third oxide semiconductor layer 24 has hydrogen and a second conductivity-type third oxide semiconductor, and a percentage of the hydrogen with respect to a metal constituting the third oxide semiconductor is equal to or greater than 40%.

Moreover, in the electricity storage device 30 according to the embodiments, the third oxide semiconductor layer 24 includes a nickel oxide (NiO_{y}Hₓ) containing hydrogen, a value of a hydrogen composition ratio x is equal to or greater than 0.35, and a value of an oxygen composition ratio y is selected value.

Moreover, the electricity storage device 30 may include a second charge layer 18 disposed between the first charge layer 16 and the third oxide semiconductor layer 24.

Moreover, the second charge layer 18 may include a second insulating material.

Moreover, the third oxide semiconductor may include NiO.

Alternatively, the second charge layer 18 may include the second insulating material and a conductivity adjusting material.

Moreover, the second oxide semiconductor may include at least one oxide selected from the group consist of an oxide of Ti, an oxide of Sn, an oxide of Zn, and an oxide of Mg.

Moreover, the conductivity adjusting material may include a first conductivity-type semiconductor or a metallic oxide.

Alternatively, the conductivity adjusting material may include at least one oxide selected from the group of consisting of an oxide of Sn, an oxide of Zn, an oxide of Ti, and an oxide of Nb.

Moreover, the second insulating material may include SiOₓ, and the conductivity adjusting material may include SnOₓ.

Alternatively, the second insulating material may include SiOₓ formed as a film from silicone oil.

Moreover, the first insulating material may include SiOₓ and the second oxide semiconductor may include TiOₓ.

Furthermore, the third oxide semiconductor layer may include a metal different from the third oxide semiconductor. In this case, such a metal may include lithium or cobalt.

Moreover, in the electricity storage device 30 according to the embodiments, a thickness of the third oxide semiconductor layer 24 may be increased. An amount of hydrogen storage of the third oxide semiconductor layer 24 can be increased and an amount of hydrogen storage to the first charge layer 16 can be increased by increasing the thickness of the third oxide semiconductor layer 24.

Moreover, a thickness of the first charge layer 16 may be increased, in the electricity storage device 30 according to the embodiments. An amount of hydrogen storage to the first charge layer 16 can be increased by increasing the thickness of the first charge layer 16.

In the electricity storage device 30 according to the embodiments, a hydrogen concentration of the third oxide semiconductor layer 24 may be increased and the first charge layer 16 may also be thickly, in order to obtain enough electricity storage capacity formed.

Alternatively, the first charge layer 16 may include a structure of at least two-layer of which compositions are different from each other. The first charge layer 16 may be formed by including a silicon oxide (SiOₓ) / a titanium oxide (TiOₓ), for example. Specifically, the first charge layer 16 may be formed by including a layered structure of SiOₓ / TiOₓ, or may be formed by including a particulate bonding structure in which the periphery of particle-shaped TiOₓ is covered with SiOₓ. Alternatively, the first charge layer 16 may include a structure into which TiOₓ and SiOₓ are mixed, or a structure in which TiOₓ is wrapped in a silicon oxide. In the above description, the compositions of the titanium oxide and the silicon oxide are respectively not limited to TiOₓ and SiOx, but may include a structure in which the composition ratio x, of TiOx and/or SiOx is changed.

Moreover, the n type oxide semiconductor may be an oxide of titanium (Ti), tin (Sn), zinc (Zn), or magnesium (Mg). Accordingly, the first charge layer 16 may be a layered structure of SiOₓ and an oxide of Ti, Sn, Zn, or Mg, or may be formed of a particulate bonding structure in which the periphery of an oxide of particle-shaped Ti, Sn, Zn, or Mg is covered with SiOₓ. Alternatively, the first charge layer 16 may include a configuration in which a molecule or molecular group of SiOₓ and an oxide of Ti, Sn, Zn, or Mg is surrounded by SiOx (amorphous).

Alternatively, the first charge layer 16 may include a porous structure.

### (First Charge Layer)

The first charge layer 16 is a layer for storing hydrogen which is generated at the time of charging. In the first charge layer 16, a reaction of M + H₂O + e⁻→MH + OH⁻ progresses at the time of charging, and a reaction of MH + OH⁻ → M + H₂O + e⁻ progresses at the time of discharging. If the first charge layer 16 is made porous, efficiency of storing the hydrogen can be increased. Moreover, the hydrogen storage and electrical conductivity can be optimized if the first charge layer 16 is formed as a plurality of layers. It can be optimized by forming the second oxide semiconductor by using an oxide of Ti, Sn, Zn or Mg.

### (Second Charge Layer)

The second charge layer 18 is a buffer layer for adjusting movement of H⁺ and electrons (e⁻).

### (P type Oxide Semiconductor Layer)

The oxide semiconductor layer 24 constitutes a pn junction with respect to the n type semiconductor of the first charge layer 16 (second oxide semiconductor), and can suppress an electric charge leak at the time of charging. It is possible to increase a supply amount of the hydrogen to the first charge layer 16 by forming the p type oxide semiconductor layer 24 as a nickel oxide (NiO_{y}Hₓ) containing hydrogen.

### (N type Oxide Semiconductor Layer)

As shown in Fig. 1, electricity storage device 30 according to the embodiments may include the first electrode 12 and the second electrode 26; the first oxide semiconductor layer 14 may include an n type first oxide semiconductor layer, and may be connected to the first electrode 12; the second oxide semiconductor may include an n type second oxide semiconductor; and the third oxide semiconductor layer 24 may include a p type third oxide semiconductor layer, and may be connected to the second electrode 26.

### (Manufacturing Method)

A manufacturing method of the electricity storage device 30 according to the embodiments includes: forming a first conductivity-type first oxide semiconductor 14; forming a first charge layer 16 composed by including a first insulating material and a first conductivity-type second oxide semiconductor on the first oxide semiconductor layer 14; forming a second charge layer 18 on the first charge layer 16; and forming a third oxide semiconductor layer 24 on the second charge layer 18 by a sputtering deposition method.

In the embodiments, in the forming of the third oxide semiconductor layer 24, metallic nickel Ni may be used as a target material at the time of the sputtering, and vapor and water may be supplied in the chamber, and a flow rate of sputtering may be increased.

Moreover, in the forming of the third oxide semiconductor layer 24, Ni atoms are excited from the target due to an ion bombardment with argon ions Ar⁺, and the excited Ni atoms react with the hydrogen and oxygen in the chamber and undergo a sputter deposition reaction, and thereby the third oxide semiconductor layer 24 containing hydrogen may be deposited thereon.

### - n type Oxide Semiconductor Layer 14 -

A TiOₓ layer is formed as a film on the first electrode 12 which constitutes a lower electrode, for example by a sputtering deposition method. In this case, Ti or TiOₓ can be used as a target. The layer thickness of the n type oxide semiconductor layer 14 is approximately 50 nm to 200 nm, for example. In addition, a tungsten (W) electrode or the like can be applied to the first electrode 12, for example.

### - First Charge Layer 16 -

A chemical solution is formed by stirring titanium fatty acid and silicone oil with a solvent. The aforementioned chemical solution is coated on the n type oxide semiconductor layer 14 by means of a spin coater. The rotational frequency thereof is approximately 500 to approximately 3000 rpm. It is dried on a hot plate after the coating. The drying temperature on the hot plate is approximately 30°C to approximately 200°C, for example, and the drying time thereon is approximately 5 minutes to approximately 30 minutes, for example. It is fired after the drying. In the firing performed after the drying, it is fired in the atmosphere using a baking furnace. The firing temperature is approximately 300°C to approximately 600°C, and the firing time is approximately 10 minutes to approximately 60 minutes.

Consequently, aliphatic acid salt is decomposed and then a fine particle layer of a titanium dioxide covered with a silicone insulating film is formed. The above-mentioned manufacturing (preparation) method of forming the titanium dioxide layer covered with the silicone insulating film is a coating and thermodecomposition method. More specifically, the aforementioned layer has a structure where a metallic salt of the titanium dioxide coated with silicone is embedded in the silicone layer. After the firing, UV irradiation by means of a low pressure mercury lamp is implemented. The UV irradiation time is approximately 10 minutes to approximately 100 minutes. The layer thickness of the first charge layer 16 is approximately 200 nm to approximately 2000 nm, for example.

### - Second Charge Layer (Buffer Layer) 18 -

A chemical solution is formed by stirring silicone oil with a solvent. The aforementioned chemical solution is coated on the first charge layer 16 by means of the spin coater. The rotational frequency thereof is approximately 500 to approximately 3000 rpm. It is dried on a hot plate after the coating. The drying temperature on the hot plate is approximately 50°C to approximately 200°C, for example, and the drying time thereon is approximately 5 minutes to approximately 30 minutes, for example. Furthermore, it is fired after the drying. In the firing performed after the drying, it is fired in the atmosphere using a baking furnace. The firing temperature is approximately 300°C to approximately 600°C, and the firing time is approximately 10 minutes to approximately 60 minutes. After the firing, UV irradiation by means of a low pressure mercury lamp is implemented. The UV irradiation time is approximately 10 minutes to approximately 60 minutes. The layer thickness of the second charge layer (buffer layer) 18 after the UV irradiation is approximately 10 nm to approximately 100 nm, for example.

### - p type Third Oxide Semiconductor Layer 24 -

The second charge layer 18 is formed by forming a nickel oxide (NiO_{y}Hₓ) film containing hydrogen through the sputtering deposition method. In this case, Ni or NiO can be used as a target. Water is extracted from vapor or moisture in the chamber of the sputter deposition apparatus. A film thickness of the p type oxide semiconductor layer (nickel oxide containing hydrogen (NiO_{y}Hₓ)) 24 is approximately 200 nm to approximately 1000 nm, for example.

### - Second Electrode 26 -

The second electrode 26 as an upper electrode is formed by forming Al as a film by means of a sputtering deposition method or a vacuum evaporation method, for example. The second electrode 26 can be formed on the p type oxide semiconductor layer (nickel oxide containing hydrogen (NiO_{y}Hₓ)) 24 using an Al target. The second electrode 26 may be formed only on a specified region using a stainless steel mask, for example.

### (Configuration of p type Oxide Semiconductor Layer Containing Hydrogen)

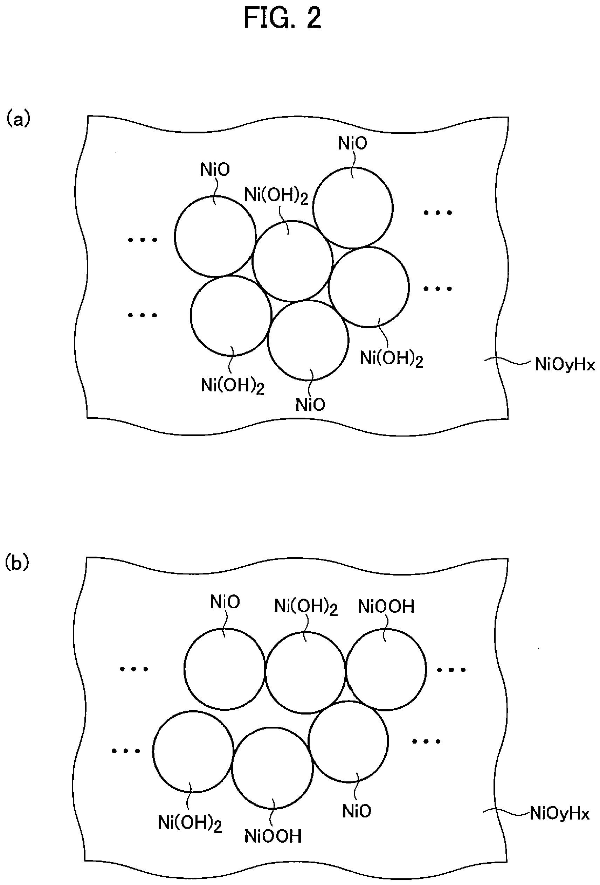

Fig. 2(a) shows a schematic configuration example of a p type oxide semiconductor layer 24, in the electricity storage device 30 according to the embodiments. Moreover, Fig. 2(b) shows another schematic configuration example of the p type oxide semiconductor layer 24.

In the electricity storage device 30 according to the embodiments, the p type oxide semiconductor layer 24 is shown as a mixture layer of a nickel oxide NiO and a nickel hydroxide Ni(OH)₂, for example, as shown in Fig. 2(a). As a result, the p type oxide semiconductor layer 24 is shown as a nickel oxide (NiO_{y}Hₓ) containing hydrogen.

Alternatively, in the electricity storage device 30 according to the embodiments, the p type oxide semiconductor layer 24 is shown as a mixture layer of a nickel oxide NiO, a nickel hydroxide Ni(OH)₂, and a nickel oxyhydroxide NiOOH, for example, as shown in Fig. 2(b). As a result, the p type oxide semiconductor layer 24 is shown as a nickel oxide (NiO_{y}Hₓ) containing hydrogen.

### (Relationship between Amount of Discharged Charge Q_{D} and Amount of Hydrogen C_{H})

A relationship between total amount of hydrogen C_{H} in the p type oxide semiconductor layer 24 and the amount of discharged charge Q_{D} proportional to the discharging time T_{D} of the electricity storage device 30 are measured on the basis of an analysis result of Secondary Ion Mass Spectrometry (SIMS).

A charging voltage is applied to the electricity storage device 30 according to the embodiments for a predetermined time, and then a state between the first electrode E1 and the second electrode E2 is shifted to a opened state to measure the discharging time T_{D}.

The discharging time T_{D} of the electricity storage device 30 is changed by changing film formation conditions (including a film thickness) of the p type oxide semiconductor layer 24. It is proved that the discharging time T_{D} can be increased by changing a sputtering flow rate condition and the film thickness.

The discharging time T_{D} of the electricity storage device 30 can be increased by increasing the film thickness of the p type oxide semiconductor layer 24.

The discharging time T_{D} can be increased by increasing the flow rate (pressure) of sputtering. Specifically, for example, it is proved that the discharging time T_{D} can be increased by increasing the flow rate of Ar/O₂ in the chamber in the sputtering.

It is also proved that the discharging time T_{D} can be increased by increasing the film thickness t_{ch} of the first charge layer 16, in the electricity storage device 30 according to the embodiments.

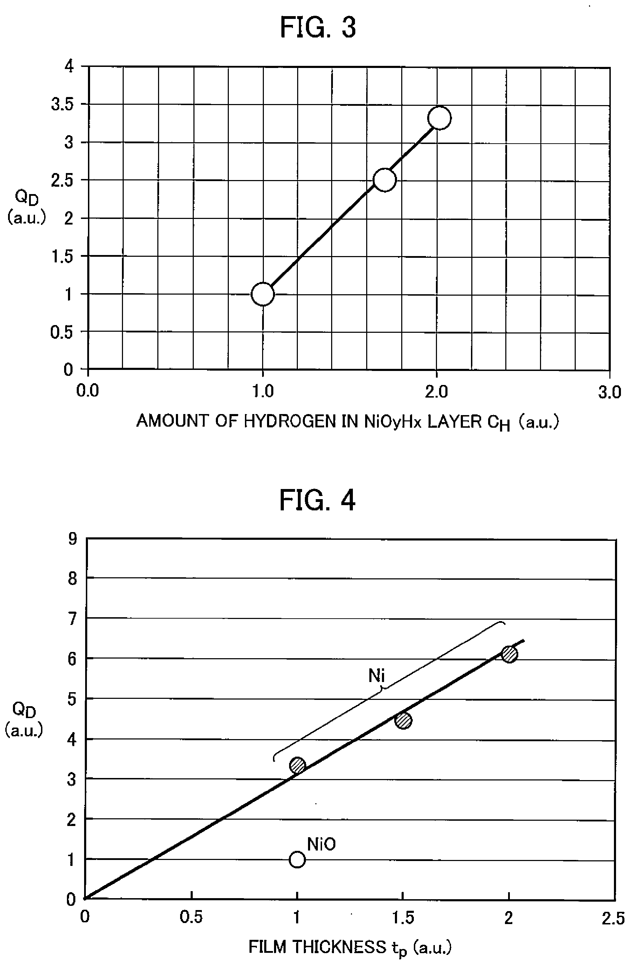

Fig. 3 shows a relationship between the amount of discharged charge Q_{D} and the amount of hydrogen C_{H} in the p type oxide semiconductor layer 24, in the electricity storage device according to the embodiments. As shown in Fig. 3, the relationship between the amount of discharged charge Q_{D} and the amount of hydrogen C_{H} in the nickel oxide (NiO_{y}Hₓ) 24 containing hydrogen is in a proportionality relation. As the amount of hydrogen C_{H} is increased, the amount of discharged charge Q_{D} is increased and the electricity storage performance is also improved.

### (Relationship between Amount of Discharged Charge Q_{D} and Thickness tₚ of p type Oxide Semiconductor Layer)

The additive amount of the hydrogen H in the p type oxide semiconductor layer (nickel oxide containing hydrogen (NiO_{y}Hₓ)) 24 is substantially constant in a depth direction of the film, from the analysis result of the SIMS. Accordingly, the total amount of hydrogen in the p type oxide semiconductor layer 24 is increased in proportion to the thickness tₚ of the p type oxide semiconductor layer 24. Therefore, a relationship between the film thickness and the discharging time when the thickness tₚ of the p type oxide semiconductor layer 24 is changed under the same film formation conditions is measured to obtain a relationship between the amount of discharged charge Q_{D} and the thickness tₚ of the p type oxide semiconductor layer 24.

More specifically, Fig. 4 shows a relationship between the amount of discharged charge Q_{D} and the thickness tₚ of the p type oxide semiconductor layer 24, in the electricity storage device according to the embodiments. Metallic nickel Ni is used as a target material at the time of the sputtering. In Fig. 4, the reference sign NiO indicates a case where a nickel oxide is used as a target material at the time of the sputtering (reference example).

As shown in Fig. 4, the relationship between the amount of discharged charge Q_{D} and the thickness tₚ of the p type oxide semiconductor layer 24 is in a proportionality relation. As the thickness tₚ is increased, the amount of discharged charge Q_{D} is increased and the electricity storage performance can also be improved.

### (Result of X-Ray Diffraction Measurement)

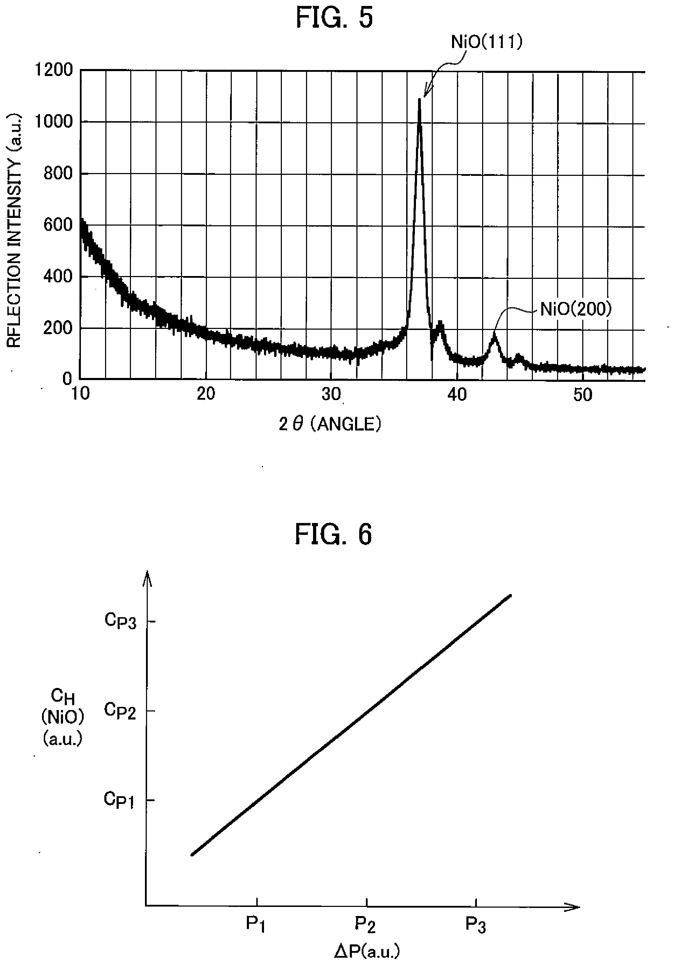

Fig. 5 shows a measured result of X-ray diffraction (XRD) of the p type oxide semiconductor layer 24, in the electricity storage device according to the embodiments. As a result of XRD measurement, NiO (111) plane 37 degrees and (200) plane 43 degrees are observed from the results of 2θ=37 degrees and 2θ=43 degrees.

### (Relationship between Amount of Hydrogen C_{H} and Pressure ΔP)

Fig. 6 is a schematic diagram for explaining a relationship between the amount of hydrogen C_{H} of the p type oxide semiconductor layer 24 and the pressure ΔP in sputter deposition, in the electricity storage device according to the embodiments. In this case, the pressures ΔP=P₁, P₂, P₃ are linearly increased and the amounts of hydrogen C_{H}=C_{P1}, C_{P2}, C_{P3} respectively corresponding thereto are also linearly increased. The pressure ΔP can be changed by increasing the flow rate of Ar/O₂ in the chamber, in the sputtering.

As shown in Fig. 6, the relationship between the amount of hydrogen C_{H} and the pressure ΔP in the p type oxide semiconductor layer 24 is in a proportionality relation, the amount of the hydrogen C_{H} can be increased by increasing the pressure ΔP, and the discharging time T_{D} can also be increased accordingly.

### (Relationship between Discharging Time T_{D} and Thickness tₚ of p type Oxide Semiconductor Layer)

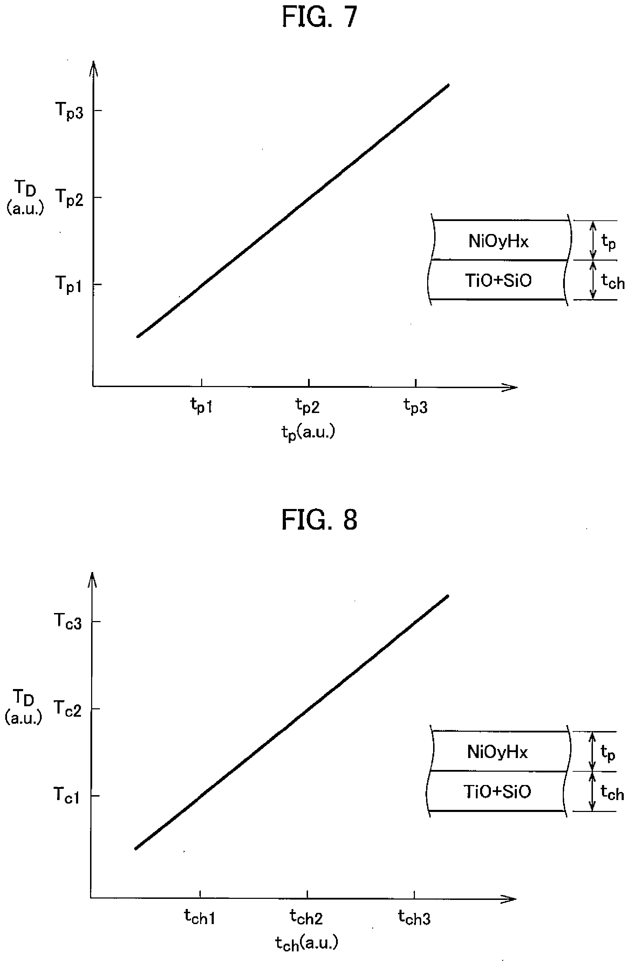

Fig. 7 schematically shows a relationship between the discharging time T_{D} and the thickness tₚ of the p type oxide semiconductor layer 24, in the electricity storage device 30 according to the embodiments. In this case, the thicknesses tₚ=tₚ₁, tₚ₂, tₚ₃ are linearly increased and the discharging times T_{D}=T_{P1}, T_{P2}, T_{P3} respectively corresponding thereto are also linearly increased. Since the thickness tₚ of the p type oxide semiconductor layer 24 is proportional to the amount of added hydrogen from the analysis result of the SIMS, the amount of added hydrogen in the p type oxide semiconductor layer 24 can be increased by increasing the thickness tₚ.

In the electricity storage device 30 according to the embodiments, as shown in Fig. 7, the relationship between the discharging time T_{D} and the thickness tₚ of the p type oxide semiconductor layer 24 is in a proportionality relation, the amount of the hydrogen C_{H} can be increased by increasing the thickness tₚ, and the discharging time T_{D} can also be increased accordingly.

### (Relationship between Discharging Time T_{D} and Thickness t_{ch} of First Charge Layer)

Fig. 8 schematically shows a relationship between the discharging time T_{D} and the thickness t_{ch} of the first charge layer 16, in the electricity storage device 30 according to the embodiments. In this case, the thicknesses t_{ch}=t_{ch1}, t_{ch2}, t_{ch3} of the first charge layer 16 are increased, and the discharging times T_{D}=T_{c1}, T_{c2}, T_{c3} corresponding thereto are also increased.

In the electricity storage device 30 according to the embodiments, as shown in Fig. 8, the relationship between the discharging time T_{D} and the thickness t_{ch} of the first charge layer 16 is in a proportionality relation, the amount of the hydrogen storage to the first charge layer 16 can be increased by increasing the thickness t_{ch}, and the discharging time T_{D} can also be increased accordingly.

### (Sputter Deposition Apparatus)

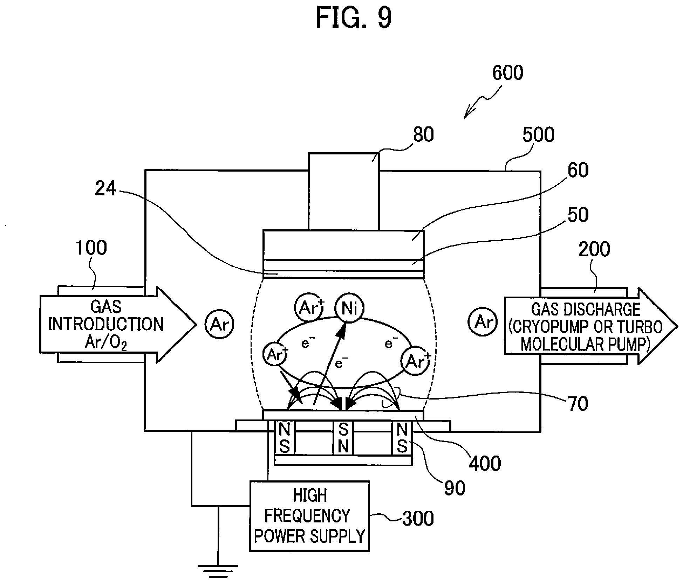

Fig. 9 shows a schematic configuration of a sputter deposition apparatus 600 to be applied to the manufacturing method of the electricity storage device 30 according to the embodiments. Alternatively, a processable batch type apparatus capable of processing a plurality of sheets thereof composed by extending the device configuration shown in Fig. 9.

As shown in Fig. 9, the sputter deposition apparatus 600 to be applied to the manufacturing method of the electricity storage device 30 according to the embodiments includes a chamber 500, including a gas introduction port 100, a gas exhaust port 200, a cylinder-shaped upper electrode 80, and a target 400.

A heater 60 and a sample substrate 50 which can be heated with the heater 60 are disposed on the upper electrode 80.

Moreover, a magnet 90 is connected to the target 400, and thereby magnetic force lines 70 can be generated on the target 400 as shown in Fig. 9.

Argon (Ar) gas and oxygen (O₂) gas can be supplied into the chamber 500 at a predetermined flow rate from the gas introduction port 100.

Exhaust gas after the sputter deposition reaction is discharged from the gas exhaust port 200. The gas exhaust port 200 is connected to a cryopump or a turbo molecular pump, for example, disposed outside the chamber 500.

As the target 400, metal Ni or NiO can be applied.

As the sample substrate 50, a substrate sample of which a exposed surface is the first charge layer 16 can be applied, wherein the substrate sample has a layered structure composed by including the first charge layer 16 / the first oxide semiconductor layer 14 or a layered structure composed by including the first charge layer 16 / the first oxide semiconductor layer 14 / the first electrode (E1), in the electricity storage device 30 according to the embodiments.

A high frequency power supply 300 which can be excited at a predetermined frequency is connected between the upper electrode 80 electrically connected to the chamber 500 and the target 400 electrically insulated to the chamber 500. Consequently, a given amount of plasma composed by including argon ions Ar⁺ and electrons e⁻ is generated between the upper electrode 80 and the target 400 in the chamber 500, and thereby Ni atoms are excited from the target 400 due to an ion bombardment with the argon ions Ar⁺. The excited Ni atoms react with the hydrogen and the oxygen in the chamber, and undergo a sputter deposition reaction on a front side surface of the sample substrate 50, and thereby the p type oxide semiconductor layer 24 containing hydrogen is deposited thereon. As a result, the p type oxide semiconductor layer 24 is shown as a nickel oxide (NiO_{y}Hₓ) containing hydrogen.

Even if conversion is performed per unit film thickness (volume) of the p type oxide semiconductor layer 24, the discharging time can be increased by increasing the hydrogen (H) concentration. Accordingly, vapor and H₂O may be supplied into the chamber at the time of the sputtering, for example.

### (RBS)

Although SIMS can perform a mutual comparison but cannot measure an absolute amount, it was also quantified by Rutherford Backscattering Spectroscopy (RBS). In the RBS, when high-speed ions (He⁺, H⁺, and the like) are emitted to the sample, a part of the incident ions receives elastic (Rutherford) scattering by the atomic nucleus in the sample. Energy of the scattered ions varies depending on the masses and positions (depth) of the object atoms. An elemental composition of the sample in the depth direction can be obtained from the energy and the amount of the scattered ions. Consequently, as an example, a result of 35.20% of Ni content, 35.60% of O content, and 29.00% of H content is obtained, and thereby it is proved that approximately 30% of hydrogen (H) is contained in the atomic weight ratio.

In the electricity storage device 30 according to the embodiments, it is estimated that nickel oxide (NiO_{y}Hₓ) containing 15% or more of hydrogen (H) in the atomic weight ratio is required for discharging. Alternatively, it is preferable that it may be y = optional value and x = 0.35 or more for the amount of the hydrogen for the nickel oxide (NiO_{y}Hₓ) which contains hydrogen (H), in the chemical formula.

When H is purely contained in the nickel oxide (NiO), x of NiOHₓ may be approximately 0.35. However, since NiOOH or Ni(OH)₂ may be contained in the nickel oxide (NiO), it is preferable that it may be y = optional value and x = 0.35 or more for the nickel oxide (NiO_{y}Hₓ) containing hydrogen.

Although only NiO is detected by the XRD, this is because a case where oxygen exceeding 1 with respect to Ni by measurement of the RBS is confirmed, and the amount of the hydrogen contributes to the charging and discharging if defining the amount of the hydrogen on the basis of Ni. As a result of the RBS measurement, NiO_{y}Hₓ (where y =1 and x = 0.8) is obtained in a certain sample, and NiO_{y}Hₓ (where y =1.5 and x = 0.4) is obtained in another sample, for example.

According to the embodiments, there can be provided the electricity storage device capable of increasing the electricity storage capacity per unit volume (weight), and the manufacturing method for such an electricity storage device.

### [Other embodiments]

As explained above, the embodiments have been described, as a disclosure including associated description and drawings to be construed as illustrative, not restrictive. This disclosure makes clear a variety of alternative embodiments, working examples, and operational techniques for those skilled in the art.

For example, a structure of the electricity storage device 30 according to the embodiments is made in a sheet shape by using stainless steel foil as a substrate. Subsequently, this sheet may be laminated to produce the electricity storage device 30 with a required capacity.

For example, an electricity storage device with a required capacity can be manufactured by opposing two sheets of the second electrodes (upper electrodes), inserting an electrode (thin metal foil) therebetween, and laminating the two sheets in multiple layers. It may be sealed with a laminate or the like after the laminating.

Such being the case, the embodiments cover a variety of embodiments, whether described or not.

### INDUSTRIAL APPLICABILITY

The electricity storage device of the embodiments can be utilized for various consumer equipment and industrial equipment, and can be applied to wide applicable fields, such as electricity storage devices for system applications capable of transmitting various kinds of sensor information with low power consumption, e.g. communication terminals and electricity storage devices for wireless sensor networks.

### Reference Signs List

- 12:: First electrode (E1)
- 14:: First oxide semiconductor layer
- 16:: First charge layer
- 18:: Second charge layer
- 24:: Third oxide semiconductor layer
- 26:: Second electrode (E2)
- 30:: Electricity storage device
- 50:: Sample substrate
- 60:: Heater
- 70:: Magnetic force line
- 80:: Upper electrode
- 90:: Magnet
- 100:: Gas introduction port
- 200:: Gas exhaust port
- 300:: High frequency power supply
- 400:: Target
- 500:: Chamber
- 600:: Sputter deposition apparatus

## Claims

1. An electricity storage device (30) comprising:
a first oxide semiconductor layer (14) having a first conductivity-type first oxide semiconductor;
a first charge layer (16) disposed on the first oxide semiconductor layer (14), the first charge layer (16) composed by comprising a first insulating material and a second oxide semiconductor, the second oxide semiconductor comprising the first conductivity-type; and
a third oxide semiconductor layer (24) disposed on the first charge layer (16), wherein
the third oxide semiconductor layer (24) has hydrogen and a second conductivity-type third oxide semiconductor, and a percentage of the hydrogen with respect to a metal constituting the third oxide semiconductor is equal to or greater than 40%.

2. The electricity storage device according to claim 1, further comprising
a second charge layer (18) disposed between the first charge layer (16) and the third oxide semiconductor layer (24).

3. The electricity storage device according to claim 2, wherein
the second charge layer (18) comprises a second insulating material.

4. The electricity storage device according to any one of claims 1-3, wherein
the third oxide semiconductor comprises NiO.

5. The electricity storage device according to claim 2, wherein
the second charge layer (18) comprises a second insulating material and a conductivity adjusting material.

6. The electricity storage device according to any one of claims 1-5, wherein
the second oxide semiconductor comprises at least one oxide selected from the group consist of an oxide of Ti, an oxide of Sn, an oxide of Zn, and an oxide of Mg.

7. The electricity storage device according to claim 5, wherein
the conductivity adjusting material comprises a first conductivity-type semiconductor or a metallic oxide.

8. The electricity storage device according to claim 5 or 7, wherein
the conductivity adjusting material comprises at least one oxide selected from the group of consisting of an oxide of Sn, an oxide of Zn, an oxide of Ti, and an oxide of Nb.

9. The electricity storage device according to claim 5, wherein
the second insulating material comprises SiOₓ, and the conductivity adjusting material comprises SnOₓ.

10. The electricity storage device according to claim 5, wherein
the second insulating material comprises SiOₓ formed as a film from silicone oil.

11. The electricity storage device according to any one of claims 1-10, wherein
the first insulating material comprises SiOₓ, and the second oxide semiconductor comprises TiOₓ.

12. The electricity storage device according to claim 1, wherein
the third oxide semiconductor layer (24) comprises a metal different from the third oxide semiconductor.

13. The electricity storage device according to claim 12, wherein
the metal comprises lithium or cobalt.

14. An electricity storage device (30) comprising:
a first conductivity-type first oxide semiconductor;
a first charge layer (16) disposed on the first oxide semiconductor layer, the first charge layer (16) composed by comprising a first insulating material and a second oxide semiconductor, the second oxide semiconductor having the first conductivity type; and
a second conductivity-type third oxide semiconductor layer (24) disposed on the first charge layer (16), wherein
the third oxide semiconductor layer (24) comprises a nickel oxide (NiO_{y}Hₓ) containing hydrogen, and a value of a hydrogen composition ratio x is 0.35 or more, and a value of the oxygen composition ratio y is an optional value.

## Patentansprüche

1. Stromspeichervorrichtung (30), umfassend:
eine erste Oxidhalbleiterschicht (14), die einen ersten Oxidhalbleiter von einem ersten Leitfähigkeitstyp aufweist;
eine erste Ladungsschicht (16), die auf der ersten Oxidhalbleiterschicht (14) angeordnet ist, wobei die erste Ladungsschicht (16) aus einem ersten isolierenden Material und einem zweiten Oxidhalbleiter besteht, wobei der zweite Oxidhalbleiter den ersten Leitfähigkeitstyp aufweist; und
eine dritte Oxidhalbleiterschicht (24), die auf der ersten Ladungsschicht (16) angeordnet ist, wobei
die dritte Oxidhalbleiterschicht (24) Wasserstoff und einen dritten Oxidhalbleiter von einem zweiten Leitfähigkeitstyp aufweist, und ein Prozentsatz des Wasserstoffs in Bezug auf ein Metall, das den dritten OxidHalbleiter bildet, gleich oder größer als 40% ist.

2. Stromspeichervorrichtung nach Anspruch 1, ferner umfassend
eine zweite Ladungsschicht (18), die zwischen der ersten Ladungsschicht (16) und der dritten Oxidhalbleiterschicht (24) angeordnet ist.

3. Stromspeichervorrichtung nach Anspruch 2, wobei
die zweite Ladungsschicht (18) ein zweites isolierendes Material umfasst.

4. Stromspeichervorrichtung nach einem der Ansprüche 1-3, wobei
der dritte Oxidhalbleiter NiO umfasst.

5. Stromspeichervorrichtung nach Anspruch 2, wobei
die zweite Ladungsschicht (18) ein zweites Isoliermaterial und ein Material zur Einstellung der Leitfähigkeit umfasst.

6. Stromspeichervorrichtung nach einem der Ansprüche 1-5, wobei
der zweite Oxidhalbleiter mindestens ein Oxid umfasst, das aus der Gruppe ausgewählt ist, die aus einem Oxid von Ti, einem Oxid von Sn, einem Oxid von Zn und einem Oxid von Mg besteht.

7. Stromspeichervorrichtung nach Anspruch 5, wobei
das Material zur Einstellung der Leitfähigkeit einen Halbleiter des ersten Leitfähigkeitstyps oder ein Metalloxid umfasst.

8. Stromspeichervorrichtung nach Anspruch 5 oder 7, wobei
das Material zur Einstellung der Leitfähigkeit mindestens ein Oxid umfasst, das aus der Gruppe ausgewählt ist, die aus einem Oxid von Sn, einem Oxid von Zn, einem Oxid von Ti und einem Oxid von Nb besteht.

9. Stromspeichervorrichtung nach Anspruch 5, wobei
das zweite isolierende Material SiOₓ umfasst und das Material zur Einstellung der Leitfähigkeit SnOx umfasst.

10. Stromspeichervorrichtung nach Anspruch 5, wobei
das zweite isolierende Material SiOₓ umfasst, das als Film aus Silikonöl gebildet wird.

11. Stromspeichervorrichtung nach einem der Ansprüche 1-10, wobei
das erste isolierende Material SiOₓ umfasst und der zweite Oxidhalbleiter TiOₓ umfasst.

12. Stromspeichervorrichtung nach Anspruch 1, wobei
die dritte Oxidhalbleiterschicht (24) ein anderes Metall als der dritte Oxidhalbleiter enthält.

13. Stromspeichereinrichtung nach Anspruch 12, wobei
das Metall Lithium oder Kobalt enthält.

14. Stromspeichervorrichtung (30), umfassend:
einen ersten Oxidhalbleiter von einem ersten Leitfähigkeitstyp;
eine erste Ladungsschicht (16), die auf der ersten Oxidhalbleiterschicht angeordnet ist, wobei die erste Ladungsschicht (16) aus einem ersten isolierenden Material und einem zweiten Oxidhalbleiter besteht, wobei der zweite Oxidhalbleiter den ersten Leitfähigkeitstyp aufweist; und
eine dritte Oxidhalbleiterschicht (24) von einem zweiten Leitfähigkeitstyp, die auf der ersten Ladungsschicht (16) angeordnet ist, wobei
die dritte Oxidhalbleiterschicht (24) ein Nickeloxid (NiO_{y}Hₓ) umfasst, das Wasserstoff enthält, und ein Wert eines Wasserstoff-Zusammensetzungsverhältnisses x 0,35 oder mehr ist, und ein Wert des Sauerstoff-Zusammensetzungsverhältnisses y ein optionaler Wert ist.

## Revendications

1. Dispositif de stockage d'électricité (30) comprenant :
une première couche en oxyde semiconducteur (14) qui comporte un premier oxyde semiconducteur d'un premier type de conductivité ;
une première couche de charge (16) qui est disposée sur la première couche en oxyde semiconducteur (14), la première couche de charge (16) étant constituée de telle sorte qu'elle comprenne un premier matériau isolant et un deuxième oxyde semiconducteur, le deuxième oxyde semiconducteur présentant le premier type de conductivité ; et
une troisième couche en oxyde semiconducteur (24) qui est disposée sur la première couche de charge (16) ; dans lequel :
la troisième couche en oxyde semiconducteur (24) comporte de l'hydrogène et un troisième oxyde semiconducteur d'un second type de conductivité, et un pourcentage de l'hydrogène par rapport à un métal qui constitue le troisième oxyde semiconducteur est égal ou supérieur à 40 %.

2. Dispositif de stockage d'électricité selon la revendication 1, comprenant en outre :
une seconde couche de charge (18) qui est disposée entre la première couche de charge (16) et la troisième couche en oxyde semiconducteur (24).

3. Dispositif de stockage d'électricité selon la revendication 2, dans lequel :
la seconde couche de charge (18) comprend un second matériau isolant.

4. Dispositif de stockage d'électricité selon l'une quelconque des revendications 1 à 3, dans lequel :
le troisième oxyde semiconducteur comprend du NiO.

5. Dispositif de stockage d'électricité selon la revendication 2, dans lequel :
la seconde couche de charge (18) comprend un second matériau isolant et un matériau de réglage de conductivité.

6. Dispositif de stockage d'électricité selon l'une quelconque des revendications 1 à 5, dans lequel :
le deuxième oxyde semiconducteur comprend au moins un oxyde qui est sélectionné parmi le groupe qui est constitué par un oxyde de Ti, un oxyde de Sn, un oxyde de Zn et un oxyde de Mg.

7. Dispositif de stockage d'électricité selon la revendication 5, dans lequel :
le matériau de réglage de conductivité comprend un semiconducteur du premier type de conductivité ou un oxyde métallique.

8. Dispositif de stockage d'électricité selon la revendication 5 ou 7, dans lequel :
le matériau de réglage de conductivité comprend au moins un oxyde qui est sélectionné parmi le groupe qui est constitué par un oxyde de Sn, un oxyde de Zn, un oxyde de Ti et un oxyde de Nb.

9. Dispositif de stockage d'électricité selon la revendication 5, dans lequel :
le second matériau isolant comprend du SiOₓ, et le matériau de réglage de conductivité comprend du SnOₓ.

10. Dispositif de stockage d'électricité selon la revendication 5, dans lequel :
le second matériau isolant comprend du SiOₓ qui est formé en tant que film à partir d'huile silicone.

11. Dispositif de stockage d'électricité selon l'une quelconque des revendications 1 à 10, dans lequel :
le premier matériau isolant comprend du SiOₓ, et le deuxième oxyde semiconducteur comprend du TiOₓ.

12. Dispositif de stockage d'électricité selon la revendication 1, dans lequel :
la troisième couche en oxyde semiconducteur (24) comprend un métal qui est différent du troisième oxyde semiconducteur.

13. Dispositif de stockage d'électricité selon la revendication 12, dans lequel :
le métal comprend du lithium ou du cobalt.

14. Dispositif de stockage d'électricité (30) comprenant :
un premier oxyde semiconducteur d'un premier type de conductivité ;
une première couche de charge (16) qui est disposée sur la première couche en oxyde semiconducteur, la première couche de charge (16) étant constituée de telle sorte qu'elle comprenne un premier matériau isolant et un deuxième oxyde semiconducteur, le deuxième oxyde semiconducteur présentant le premier type de conductivité ; et
une troisième couche en oxyde semiconducteur d'un second type de conductivité (24) qui est disposée sur la première couche de charge (16) ; dans lequel :
la troisième couche en oxyde semiconducteur (24) comprend un oxyde de nickel (NiO_{y}Hₓ) qui contient de l'hydrogène, et une valeur d'un rapport de composition d'hydrogène x est de 0,35 ou plus, et une valeur du rapport de composition d'oxygène y est une valeur optionnelle.
